Europäisches Patentamt

European Patent Office

Office européen des brevets

(11) Publication number: **0 082 999**
**B1**

## (12) EUROPEAN PATENT SPECIFICATION

(45) Date of publication of patent specification: **01.03.89**

(51) Int. Cl.⁴: **H 01 L 29/78, H 01 L 27/08**

(21) Application number: **82111416.2**

(22) Date of filing: **09.12.82**

(54) **Speed-power scaling for MOS circuit.**

(30) Priority: **28.12.81 US 334900**

(43) Date of publication of application:
**06.07.83 Bulletin 83/27**

(45) Publication of the grant of the patent:
**01.03.89 Bulletin 89/09**

(84) Designated Contracting States:
**AT DE FR GB NL**

(56) References cited:
**US-A-3 995 172**
**US-A-4 042 839**
**IBM TECHNICAL DISCLOSURE BULLETIN, vol. 23, no. 10, March 1981, page 4461, New York, USA; K. BERNSTEIN et al.: "Four-state memory cell for read-only storage"**
**IBM TECHNICAL DISCLOSURE BULLETIN, vol. 23, no. 7B, December 1980, pages 3113-3114, New York, USA; W.R. KRAFT et al.: "Layout of a high performance CFET device configuration"**

(73) Proprietor: **THOMSON COMPONENTS-MOSTEK CORPORATION**
**1310 Electronics Drive**
**Carrollton Texas 75006 (US)**

(72) Inventor: **Sheppard, Douglas Parks**
**2370 Mockingbird**
**Grapevine Texas 76051 (US)**

(74) Representative: **Ruellan-Lemonnier, Brigitte et al**
**THOMSON-CSF SCPI 19, avenue de Messine**
**F-75008 Paris (FR)**

Courier Press, Leamington Spa, England.

## Description

The present invention pertains to MOS (metal oxide semiconductor) circuits and in particular to the control of power consumption for such circuits.

Certain types of integrated circuits such as dynamic and static random access memories can be speed sorted. The fast devices can then be sold at a premium to those customers who require high speed parts. The slower devices can then be sold to customers who do not have such a high speed requirement. This is conventional in the industry.

The power consumption of an integrated circuit is typically related to its speed. That is, the greater the speed the greater the power consumption. Therefore there is often a trade off between the speed of a part and the power it consumes. For instance US Patent 3,995,172 shows a way of obtaining a compromise for both logic as well as memory circuits with the aid of adjacent depletion and enhancement transistors conducted in parallel between common source and drain regions. The depletion region of the channel is preferably formed by ion implanting an N-type dopant into the region and the enhancement region of the channel may have the same doping level as the substrate or a P-type dopant may be ion implanted.

Read only memory (ROM) circuits are fabricated with a customer bit pattern that is unique for each customer. In a sale to a customer purchasing a ROM circuit there is generally designated a minimum operating speed for the part. When the ROM circuits are tested those circuits that do not meet this minimal requirement cannot be used for any purpose and therefore must be discarded. This can constitute a substantial overhead expense for the manufacturer of ROM circuits. A basic ROM circuit is typically designed for the widest application and then custom programmed for each individual customer application. In this case the basic circuit must have a speed capability sufficiently fast for that of the most demanding customer. Since the economies of manufacturing require one basic manufacturing process, all of the customers must receive the same basic part. Therefore many of the customers receive parts that operate at a much higher speed and consume much more power than they require. The custom design of parts would be far too expensive in this market.

In view of the problems encountered in the manufacturing of read only memories and similar type circuits, there exists a need for a circuit which can be custom produced to have any of a wide range of speed and power consumption parameters while at the same time utilizing one basic ROM circuit which is manufactured in a conventional process. To solve this problem, the invention proposes a manufacturing process as defined in claim 1.

For a more complete understanding of the present invention and the advantages thereof, reference is now made to the following description taken in conjunction with the accompanying drawings in which:

Figure 1 is a schematic illustration of a driver circuit having an N-channel depletion pull-up transistor and an N-channel enhancement pull-down transistor

Figure 2 is a plan view of a depletion transistor as it is fabricated in an integrated circuit showing the reduction in the effective width of the channel of the transistor by means of applying a second implant at an end of the channel,

Figure 3 is a plan view of a depletion transistor as it is fabricated in an integrated circuit showing the reduction in the effective width of the channel of the transistor by means of applying a second implant at a central region of the channel and

Figure 4 is a schematic illustration of the circuit equivalent to the MOS transistor shown in Figure 2.

## Detailed Description

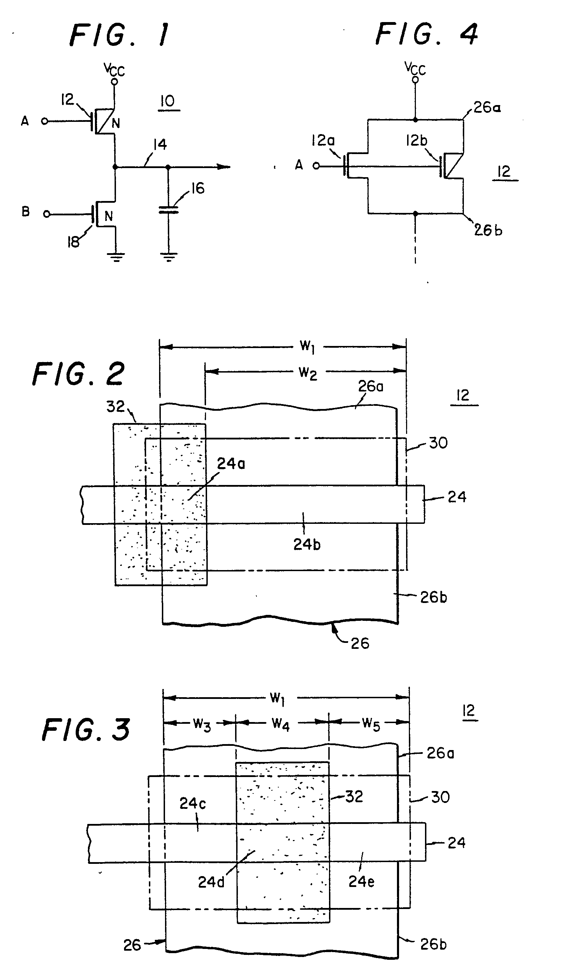

Referring now to Figure 1 there is shown a driver circuit 10 which can be widely utilized in a read only memory. The circuit 10 includes a pull-up transistor 12 which is an N-channel depletion device. The drain terminal of transistor 12 is connected to a power terminal labeled $V_{cc}$. The source terminal of transistor 12 is connected to a node 14. The node 14 has a capacitive load indicated by a capacitor 16 which is connected between node 14 and ground. The gate terminal of transistor 12 is connected to receive a signal labeled A. Circuit 10 further includes a pull-down transistor 18 which has its drain terminal connected to node 14 and its source terminal connected to ground. The gate terminal of transistor 18 is connected to receive an input signal B.

In operation the signals A and B have inverse states such that the transistors 12 and 18 are not driven to conductive states at the same time. The signal generated at the node 14 is typically utilized to drive a circuit, such as a row decoder, in a read only memory. Such a circuit generally has a substantial capacitive load as indicated by the capacitor 16. The transistor 12 is typically fabricated to have a pinch-off voltage ($V_P$) of −1.0 volts. Transistor 18 is an enhancement device.

In a first state circuit 10 drives node 14 to a high voltage level of approximately $V_{cc}$. This can be done due to the use of the depletion transistor 12. If an enhancement transistor were used in place of depletion transistor 12, the node 14 could be driven only to within one voltage threshold of the power supply $V_{cc}$ without boosting the voltage at the gate terminal of transistor 12. In a second state the node 14 is pulled to ground potential.

In a large memory the circuit 10 is replicated a great may times such that the power consumption of the overall integrated circuit memory is closely related to the power consumption of each of the driver circuits. The speed at which node 14 can be driven from a low to a high voltage state is of primary importance. For rapidly driving node 14, the transistor 12 is generally fabricated to be a relatively large device. Transistor 18 is made large enough to insure a good low level at node 14 when the gate of transistor 12 is low because transistor 12 is still conductive due to its negative threshold.

In the second state signal A is a low voltage and signal B is at a high voltage. This pulls node 14 to ground. Since transistor 12 is a depletion device, it will be somewhat conductive with a ground potential applied to the gate terminal. Under this condition, transistor 18 is driven conductive. Therefore, there will be a static current flow through transistors 12 and 18. This static current causes power consumption by circuit 10 and the power consumption is a function of the amplitude of this current.

It is further well known that the current through an MOS transistor is essentially proportional to the width of the transistor. Therefore, the static current flow through transistor 12 is essentially proportional to its width.

In the first state, signal A is a high level and signal B is at a low level. The low level of signal B turns off transistor 18, thus permitting transistor 12 to pull node 14 high. In the process of driving node 14 to a high voltage state, current will flow through transistor 12 to charge capacitor 16. The greater the current which is passed through transistor 12, the greater the rate at which capacitor 16 can be charged. As noted above, the size of transistor 12 essentially determines the amplitude of current which passes through the transistor. Therefore, the circuit 10 can be made faster by fabricating the transistor 12 to have a large channel area, width, but this increases power consumption as described above. The power consumption of circuit 10 can be reduced by fabricating the channel of transistor 12 to the relatively small, narrow, but this reduces the rate at which the node 14 can be driven. Thus, there is a trade off between speed and power consumption.

In the conventional manufacture of read only memories, a basic circuit is designed to have the fastest speed requirement for any customer. This means that the transistors, such as pull-up transistor 12, must be fabricated to be relatively large devices. This, however, means that the read only memory will have a substantial static power consumption.

In the present invention, the transistor 12 is initially fabricated in a basic circuit to have a given width for high speed operation. This width is then reduced in accordance with the customer speed/power requirements to produce a memory circuit which is optimized for a particular application.

The method for manufacturing the transistor 12 and controlling the size of its channel is illustrated in Figure 2. The channel of the transistor 12 is designated by the numeral 24. The channel is located in an active area 26 where the source is designated 26a and the drain is 26b. In integrated circuit technology the length of the channel of an MOS transistor is typically made as small as possible. The width is then selected to meet the current requirement for the transistor. For the transistor 12, the channel is fabricated to have an initial width which is indicated as $W_1$.

The transistor 12 in a preferred embodiment receives a depletion implant 30 over an area indicated by a dashed line. The depletion implant 30 fully encloses the channel 24 of the transistor. The implant 30 is applied only to the channel region within the active area 26 due to the fabrication of oxide, not shown, above the source 26a and drain 26b. The depletion implant 30 is larger than the channel 24 within the transistor to ensure that the channel is fully covered. In a selected embodiment of the present invention, the depletion implant is applied to produce a pinch-off voltage ($V_p$) of approximately −1.0 volts. This makes transistor 12 a lightly depleted device which is utilized to drive a node, such as 14, to a full $V_{cc}$.

Further in reference to Figure 2, the scaling of the power consumption for transistor 12 is carried out as follows. An enhancement implant 32 shown by the area enclosed by a solid line is applied to the transistor 12. The enhancement implant 32 is applied by means of a mask to cover a selected portion 24a of channel 24. The area of the enhancement implant 32 is larger than the channel 24 to compensate for any errors of alignment in the manufacture of the integrated circuit. The extent of overlap of the enhancement implant over the channel determines the power scaling factor for the transistor 12. In the illustrated embodiment, approximately 20% of the channel region receives the enhancement implant. This serves to reduce the effective width of the channel 24 to that shown as $W_2$. Approximately a 6.0 volt enhancement implant 32 is applied to the transistor 12. This results in a net implant of +5.0 volts in section 24a of the channel 24 and leaves a −1.0 volt implant in the remaining section 24b.

The power supply $V_{cc}$ is typically 5.0 volts which is also the limit for the input signals A and B. Under these conditions the section 24a of channel 24 cannot be driven to a conductive state. Therefore the effective conductive width of channel 24 is that of section 24b. Since the current flow through the transistor 12 is essentially proportional to the width of the channel 24, the transistor 12 has had its current flow reduced by approximately 20%. This also corresponds to the reduction in power consumption by the transistor 12.

The implant 32 need not fully block the source-drain current across the channel section it implants, but can be a selected level of implant to reduce the current flow across the channel section it implants.

In the further fabrication of the transistor 12 a polysilicon line, not shown, is fabricated directly above the channel 24 to serve as a gate for the transistor.

Although the implant 32 in Figure 2 is shown covering one end of the channel 24 it may also be placed in a center section of channel 24 leaving conductive portions on either side of the enhancement implant. This is shown in Figure 3. The implant 32 covers section 24d of the channel and does not affect sections 24c and 24e. The sections 24c, 24d and 24e have respective widths $W_3$, $W_4$ and $W_5$. The implant configuration shown in Figure 3 produces effectively the same result as that described in reference to Figure 2.

An equivalent circuit to the transistor 12 shown in Figure 2 is illustrated in Figure 4. With both depletion and enhancement sections for the channel 24, the transistor 12 can be represented as two separate transistors having a common drain and common source. A transistor 12a has the source 26a and drain 26b with the channel region corresponding to section 24a. A transistor 12b has the source 26a and drain 26b with the channel region corresponding to section 24b. The transistor 12a is an enhancement device while the transistor 12b is a depletion device. As described in reference to Figure 2 the transistor 12a has a $V_T$ of +5.0 volts and the transistor 12b has a $V_p$ of −1.0 volts. The current conductivity of transistor 12b is less than that of transistor 12 prior to the application of the enhancement implant 32. With a 5.0 volt supply the transistor 12a will not be rendered conductive. However, as noted above, the section 24a can be implanted so that transistor 12a is partially conductive.

The size of the enhancement area 32 shown in Figure 2 can be made to cover any portion of the channel 24 desired. The greater the coverage the less will be the resulting current flow through the transistor 12 and the corresponding reduced power consumption of the transistor 12. In the manufacture of ROM circuits the programming of the customer code is typically done by means of ion implantation in accordance with the pattern provided by the customer. At some state in the manufacturing process ion implantation is carried out to program the memory array of the circuit with the customer code. The method of the present invention can be easily incorporated into this programming step such that the second implantation of the channel region, enhancement implant 32, can be included in the operation of programming the customer code into the memory array of the ROM circuit. Thus, the method of the present invention can be easily incorporated into current ROM manufacturing techniques without the need for any additional manufacturing operations. The customer can further specify the speed and power consumption of his part at the same time he is specifying the bit pattern to be programmed into the memory.

In summary, a selected embodiment of the present invention comprises a method for scaling the speed and power consumption of an MOS transistor by controlling the effective width of the conductive channel of selected transistors by means of first and second ion implantation operations. The preferred application is for depletion, pull-up transistors in a read only memory circuit.

## Claims

1. A method of fabricating a MOS read only memory which includes MOS transistors to a customer's specification, comprising the steps of: fabricating a basic circuit including transistors which have a given width (W1) of the channel for high speed operations, applying a first type implant (30) to the channels (24) of certain transistors of the basic circuit which have been selected in accordance with the customer's specification, and applying a second type implant (32) to a selected portion (24a, 24d) of said channels in accordance with the customer's specification to reduce the effective width thereof, thereby reducing the source-drain current and corresponding power consumption of said transistors.

2. The method according to claim 1, characterized in that said first type implant is depletion and said second type is enhancement and said enhancement type implant is substantially greater than said depletion type implant wherein said selected portion of said channels receives a net enhancement implant.

3. The method according to any one of claims 1 and 2, characterized in that the first type implant (30) fully encloses the channel (24) of the transistor.

4. A method according to any one of claims 1 to 3, characterized in that the area of the second type implant (32) is larger than said selected channel portion (24a, 24d).

5. The method according to any one of claims 1 to 4, characterized in that the second type implant covers one end (24a) of the channel.

6. The method according to any one of claims 1 to 4, characterized in that the second type implant is placed in a center section (24d) of the channel.

## Patentansprüche

1. Verfahren zur Herstellung eines MOS-Festwertspeichers, der MoS-Transistoren enthält, nach Kundenspezifikation, dadurch gekennzeichnet, daß es folgende Schritte umfaßt: Herstellung einer Grundschaltung, die Transistoren mit einer gegebenen Kanalbreite (W1) für Hochgeschwindigkeitsbetrieb aufweist, Einbringen eines Implantats (30) eines ersten Typs in den Kanal (24) bestimmter Transistoren der Grundschaltung, die in Übereinstimmung mit der Kundenspezifikation ausgewählt wurden, und Einbringen eines Implantats (32) eines zweiten Typs in einen ausgewählten Teil (24a, 24d) der Kanäle in Übereinstimmung mit der Kundenspezifikation zur Verminderung der effektiven Breite derselben, um auf diese Weise den Source-Drain-Strom und den entsprechenden Leistungsverbrauch der Transistoren zu vermindern.

2. Verfahren nach Anspruch 1, dadurch gekennzeichnet, daß das Implantat des ersten Typs eine Verarmung und der zweite Typ eine Anreicherung ist und daß das Implantat vom Anreicherungstyp deutlich stärker ist als das Implantat des Verarmungstyps, wobei der ausgewählte Teil der Kanäle eine Netto-Implantation vom Anreicherungstyp aufnimmt.

3. Verfahren nach Anspruch 1 oder 2, dadurch gekennzeichnet, daß das Implantat (30) des ersten Typs den Kanal (24) des Transistors vollständig einschließt.

4. Verfahren nach einem der Ansprüche 1 bis 3, dadurch gekennzeichnet, daß der Flächeninhalt des Implantats (32) des zweiten Typs größer ist als der ausgewählte Kanalteil (24a, 24d).

5. Verfahren nach einem der Ansprüche 1 bis 4, dadurch gekennzeichnet, daß das Implantat des zweiten Typs ein Ende (24a) des Kanals bedeckt.

6. Verfahren nach einem der Ansprüche 1 bis 4, dadurch gekennzeichnet, daß das das Implantat des zweiten Typs in einem mittleren Abschnitt (24d) des Kanals liegt.

## Revendications

1. Procédé de fabrication, selon la spécification d'un client, d'une mémoire morte du type MOS comprenant des transistors MOS, comprenant les étapes de fabrication d'un circuit de base comprenant des transistors qui présentent une largeur donnée (W1) du canal en vue d'un fonctionnement à haute vitesse, application d'une implantation (30) d'un premier type au canaux (24) de certains transistors du circuit de base qui ont été choisis en conformité avec la spécification du client, et application d'une implantation (32) d'un second type à une partie choisie (24a, 24d) desdits canaux en conformité avec ·la spécification du client afin de réduire leur largeur effective, tout en diminuant le courant source-drain et la consommation en puissance correspondante desdits transistors.

2. Procédé selon la revendication 1, caractérisé en ce que l'implantation du premier type est un appauvrissement et ledit second type est un enrichissement, et ladite implantation du type enrichissement étant considérablement plus importante que ladite implantation du type appauvrissement, ladite partie choisie des canaux recevant une implantation nette du type enrichissement.

3. Procédé selon l'une ou l'autre des revendications 1 et 2, caractérisé en ce que l'implantation du premier type (30) enferme complètement le canal (24) du transistor.

4. Procédé selon l'une quelconque des revendications 1 à 3, caractérisé en ce que la surface occupée par l'implantation du second type (32) est plus important que ladite partie choisie de canal (24a, 24d).

5. Procédé selon l'une quelconque des revendications 1 à 4, caractérisé en ce que l'implantation du second type couvre une extrémité (24a) du canal.

6. Procédé selon l'une quelconque des revendications 1 à 4, caractérisé en ce que l'implantation du second type est localisée en une portion centrale (24d) du canal.

5

# FIG. 1

# FIG. 4

# FIG. 2

# FIG. 3